# EUROPEAN PATENT SPECIFICATION

(11) **EP 1 509 068 B1**
(45) Date of publication and mention of the grant of the patent: **07.11.2012**
(21) Application number: 03255195.4
(22) Date of filing: 21.08.2003
(51) Int. Cl.: H05K 1/02

(54) **Method of making a microstructure using a circuit board**
Verfahren zur Herstellung eine Mikrostruktur mit einer Leiterplatte
Méthode de fabrication d'une microstructure en utilisant une carte de circuit

(43) Date of publication of application: 23.02.2005
(73) Proprietor: Sentelic Corporation, Ta-An Dist., Taipei City (TW)
(72) Inventor: Ding, Pei-Pei, Hsin-Chuang City, Taipei Hsien (TW); Lin, Jao-Ching, Hsin-Chuang City, Taipei Hsien (TW)
(74) Representative: Stuttard, Garry Philip

(56) References cited:
- CH-A- 681 758
- DE-A- 4 012 100
- US-A1- 2002 027 129

## Description

The invention relates to a method of making a microstructure, more particularly to a method of making a microstructure using a circuit board.

Conventional process technologies, such as precision micro machining, electro-discharge micro machining, laser micro machining, bulk micro machining, surface micro machining, and LIGA (lithography, electroforming and molding), for fabricating microstructures are well known in the art. However, each of the aforesaid process technologies has its drawback. The conventional precision, electro-discharge and laser micro machining process technologies are capable of fabricating microstructures with high aspect ratios, but use non-batch processing techniques. Conversely, the conventional bulk and surface micro machining process technologies use batch processing techniques, but are not capable of fabricating microstructures with high aspect ratios. The conventional LIGA process technology is capable of fabricating microstructures with high aspect ratios and uses batch processing techniques, but at a relatively high cost.

In German Patent Nos. DE19739719 and DE19739722, there is disclosed a conventional method of making the microstructure using circuit boards. The method comprises the steps of patterning the printed circuit boards and stacking the printed circuit boards one above the other to form fluid channel microstructures. Although the method proposed therein permits microstructure fabrication using batch processing techniques and at a relatively low cost, it is not suited for fabricating microstructures with high aspect ratios.

Therefore, the object of the present invention is to provide a method of making high aspect ratio microstructures that uses batch processing techniques at a relatively low cost.

According to one aspect of the present invention, a method of making a microstructure comprises the steps of:
(A) providing a circuit board that includes a dielectric layer having a first surface and a second surface opposite to the first surface, and a first conductor layer formed on the first surface of the dielectric layer;
(B) forming a metal structure on the circuit board extending from the first conductor layer toward the second surface of the dielectric layer, said step (B) including the sub-steps of
   (a) forming a hole unit in the dielectric layer that extends from the second surface to the first surface, and
   (b) filling the hole unit with the metal structure; and
(C) removing at least a portion of the dielectric layer adjacent to the first conductor layer and the metal structure tc result in the microstructure having one side defined by the first conductor layer.

According to another aspect of the present invention a method of making a microstructure comprises the steps of:
(A) providing a circuit board that includes a dielectric layer having a first surface and a second surface opposite to the first surface, opposite edges interconnecting the first and second surfaces of the dielectric layer, a first conductor layer formed on the first surface of the dielectric layer, and a second conductor layer formed on the second surface of the dielectric layer;
(B) forming a metal structure on the circuit board on the opposite edges of the dielectric layer and extending from the first conductor layer toward the second surface of the dielectric layer; and
(C) removing at least a portion of the dielectric layer adjacent to the first conductor layer and the metal structure to result in the microstructure having one side defined by the metal structure.

Other features and advantages of the present invention will become apparent in the following detailed description of the preferred embodiments with reference to the accompanying drawings, of which:
Figure 1 is a flowchart of the first preferred embodiment of a method of making a microstructure using a circuit board according to the present invention;
Figure 2 is a fragmentary sectional view to illustrate a circuit board having a dielectric layer, and first and second conductor layers formed on opposite surfaces of the dielectric layer prepared according to the method of the first preferred embodiment;
Figure 3 is a fragmentary sectional view to illustrate how the dielectric layer is patterned in the method of the first preferred embodiment;
Figure 4 is a fragmentary sectional view to illustrate how a hole unit is formed in the dielectric layer according to the method of the first preferred embodiment;
Figure 5 is a fragmentary sectional view to illustrate how the hole unit is filled with a metal structure in the method of the first preferred embodiment;
Figure 6 is a fragmentary sectional view to illustrate how a portion of the dielectric layer is removed in the method of the first preferred embodiment;
Figures 7 to 9 are fragmentary sectional views to illustrate various shapes formed after removal of the portion of the dielectric layer according to the method of the first preferred embodiment;
Figure 10 is a flowchart of the second preferred embodiment of a method of making a microstructure using a circuit board according to the present invention;
Figure 11 is a fragmentary sectional view to illustrate a circuit board having a dielectric layer, and a conductor layer prepared according to the method of the second preferred embodiment;
Figure 12 is a fragmentary sectional view to illustrate how the dielectric layer is patterned in the method of the second preferred embodiment;
Figure 13 is a fragmentary sectional view to illustrate how a hole unit is formed in the dielectric layer according to the method of the second preferred embodiment;
Figure 14 is a fragmentary sectional view to illustrate how the hole unit is filled with a metal structure in the method of the second preferred embodiment;
Figure 15 is a fragmentary sectional view to illustrate how a portion of the dielectric layer is removed in the method of the second preferred embodiment;
Figure 16 is a fragmentary sectional view to illustrate a cover member disposed on the dielectric layer according to the method of the second preferred embodiment;
Figure 17 is a flowchart of the third preferred embodiment of a method of making a microstructure using a circuit board according to the present invention;
Figure 18 is a sectional view to illustrate a circuit board having a dielectric layer, and first and second conductor layers prepared according to the method of the third preferred embodiment;
Figure 19 is a sectional view to illustrate a metal structure formed on opposite edges of the dielectric layer according to the method of the third preferred embodiment;
Figure 20 is a sectional view to illustrate how removal of the dielectric layer is conducted in the method of the third preferred embodiment;
Figure 21 is a flowchart of the fourth preferred embodiment of a method of making a microstructure using a circuit board according to the present invention;
Figure 22 is a fragmentary sectional view to illustrate a circuit board having a dielectric layer, and a conductor layer prepared according to the method of the fourth preferred embodiment;
Figure 23 is a fragmentary sectional view to illustrate how the dielectric layer is patterned in the method of the fourth preferred embodiment;
Figure 24 is a fragmentary sectional view to illustrate how a hole unit is formed in the dielectric layer in the method of the fourth preferred embodiment;
Figure 25 is a fragmentary sectional view to illustrate how the hole unit is filled with a metal structure in the method of the fourth preferred embodiment;
Figure 26 is a fragmentary sectional view to illustrate a lever member disposed on the dielectric layer according to the method of the fourth preferred embodiment;
Figure 27 is a fragmentary sectional view to illustrate how removal of the dielectric layer is conducted in the method of the fourth preferred embodiment;
Figure 28 is a flowchart of the fifth preferred embodiment of a method of making a microstructure using a circuit board according to the present invention;
Figure 29 is a fragmentary sectional view to illustrate how a circuit board having a dielectric layer, a conductor layer, and a photo-resist layer is patterned according to the method of the fifth preferred embodiment;
Figure 30 is a fragmentary sectional view to illustrate how a hole unit is formed in the dielectric layer according to the method of the fifth preferred embodiment;
Figure 31 is a fragmentary sectional view to illustrate how a cover member disposed on the dielectric layer according to the method of the fifth preferred embodiment; and
Figure 32 is a sectional view to illustrate a multi-layer circuit board device that can be fabricated according to the present invention.

Before the present invention is described in greater detail, it should be noted that like elements are denoted by the same reference numerals throughout the disclosure.

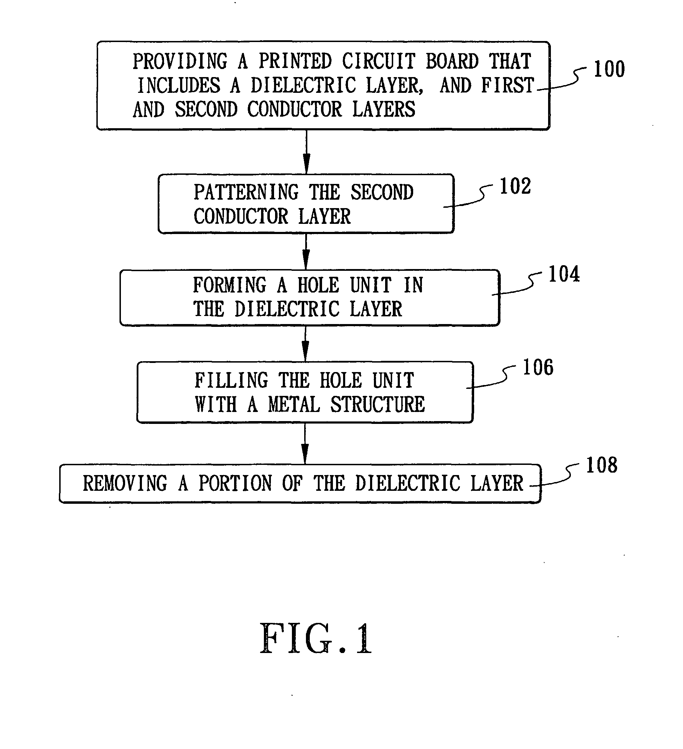

The first preferred embodiment of a method for making a microstructure according to this invention includes the steps as shown in Figure 1.

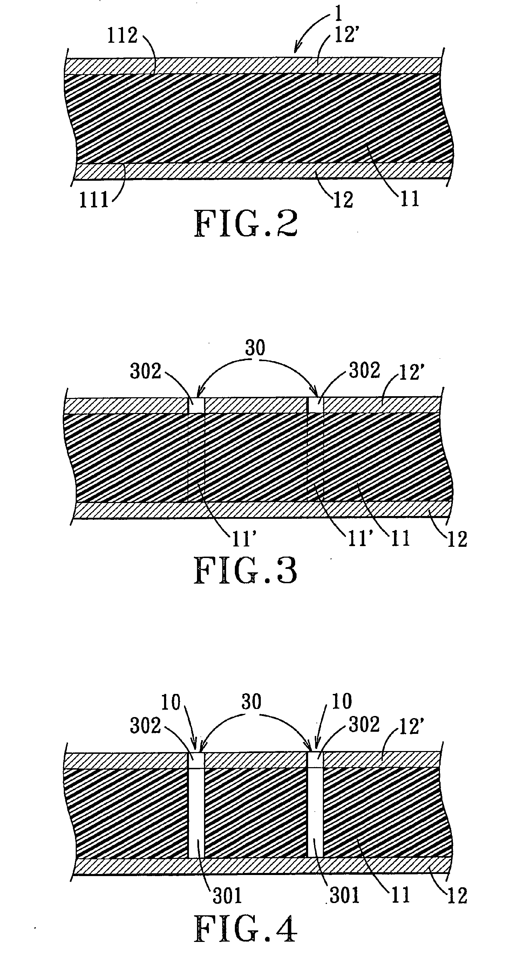

In step 100, with further reference to Figure 2, a printed circuit board 1 is provided. The printed circuit board 1 includes a dielectric layer 11 that has a first surface 111 and a second surface 112 opposite to the first surface 111, and a first conductor layer 12 formed on the first surface 111 of the dielectric layer 11. In this embodiment, the dielectric layer 11 is made from epoxy resin.

The printed circuit board 1 further includes a second conductor layer 12' formed on the second surface 112 of the dielectric layer 11. In this embodiment, the first and second conductor layers 12, 12' are made from copper foil.

In step 102, with further reference to Figure 3, the second conductor layer 12' is patterned to expose parts 11' of the second surface 112 of the dielectric layer 11. In this embodiment, the second conductor layer 12' is patterned with two parallel lines 30. The second conductor layer 12' is then etched, in a known manner, to form recesses 302 in the second conductor layer 12' corresponding to the pattern 30.

In step 104, with further reference to Figure 4, a hole unit 10 is formed in the exposed parts 11' (see Figure 3) of the second surface 112 of the dielectric layer 11. The hole unit 10 includes first and second holes 301. In this embodiment, each of the first and second holes 301 of the hole unit 10 extends from the second surface 112 to the first surface 111. Preferably, the hole unit 10 is formed by dry etching. In an alternative embodiment, the hole unit 10 is formed by wet etching.

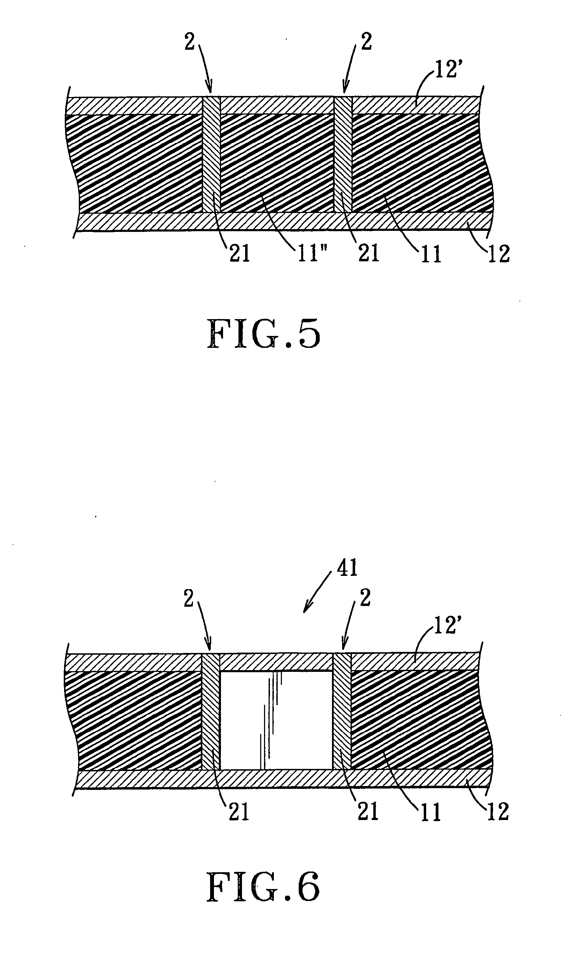

In step 106, with further reference to Figure 5, the hole unit 10 (see Figure 4) is filled with a metal structure 2. The metal structure 2 includes first and second metal members 21. In this embodiment, each of the first and second metal members 21 of the metal structure 2 extends from the first conductor layer 12 into the second conductor layer 12'. Moreover, each of the first and second metal members 21 of the metal structure 2 electrically interconnects the first and second conductor layers 12, 12'. Further, each of the first and second metal members 21 of the metal structure 2 is preferably made from copper. It is noted that the metal structure 2 may be formed by electroforming or electrodeposition. In an alternative embodiment, each of the first and second metal members 21 of the metal structure 2 thermally interconnects the first and second conductor layers 12, 12'.

In step 108, with further reference to Figures 6 to 9, a portion 11" (see Figure 5) of the dielectric layer 11 is removed to result in the microstructure 41. The removed portion 11" of the dielectric layer 11 is adjacent to the first and second conductor layers 12, 12', and the first and second metal members 21 of the metal structure 2. In this embodiment, as best shown in Figure 6, the microstructure 41 is a hollow microstructure that has four sides defined by the first and second metal members 21 of the metal structure 2, and the first and second conductor layers 12, 12'. The microstructure 41 of this embodiment is suitable for applications, such as fluid transport, mixing, and flow control. Preferably, the removal of the portion 11" of the dielectric layer 11 is conducted through wet etching. In alternative embodiments, the removal of the portion 11" of the dielectric layer 11 is conducted through one of laser ablation, dry etching, precision machining and pyrolysis.

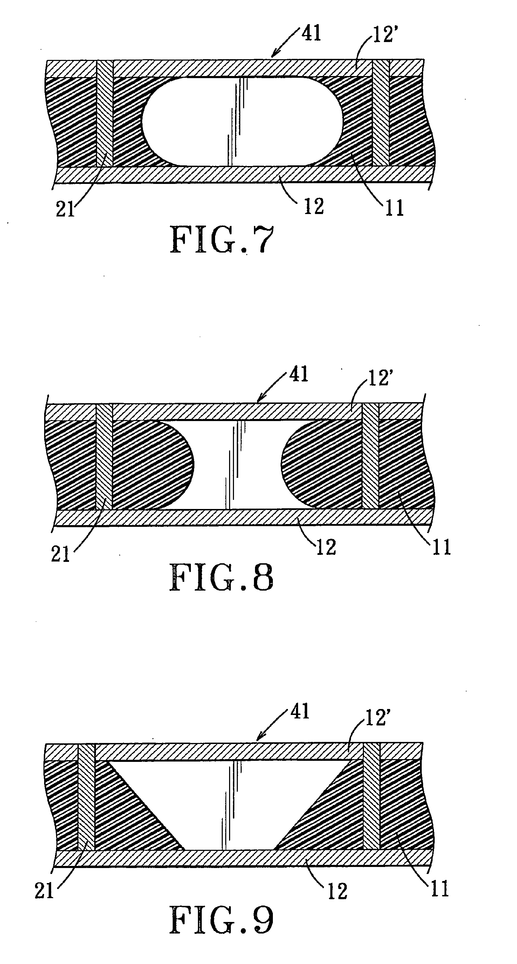

The portion 11" of the dielectric layer 11 may be removed to form various shapes to suit different applications, as best shown in Figures 7 to 9.

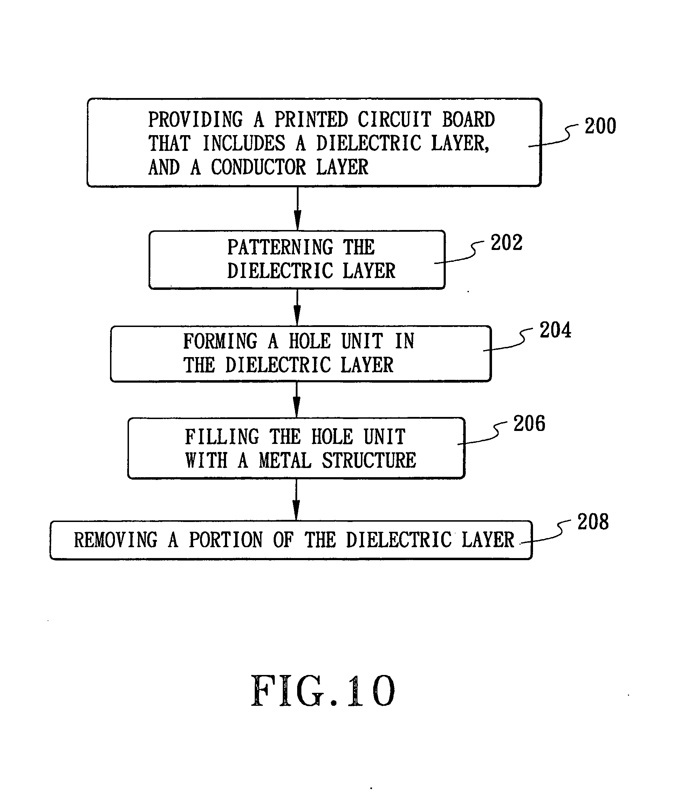

The second preferred embodiment of a method for making a microstructure according to this invention includes the steps as shown in Figure 10.

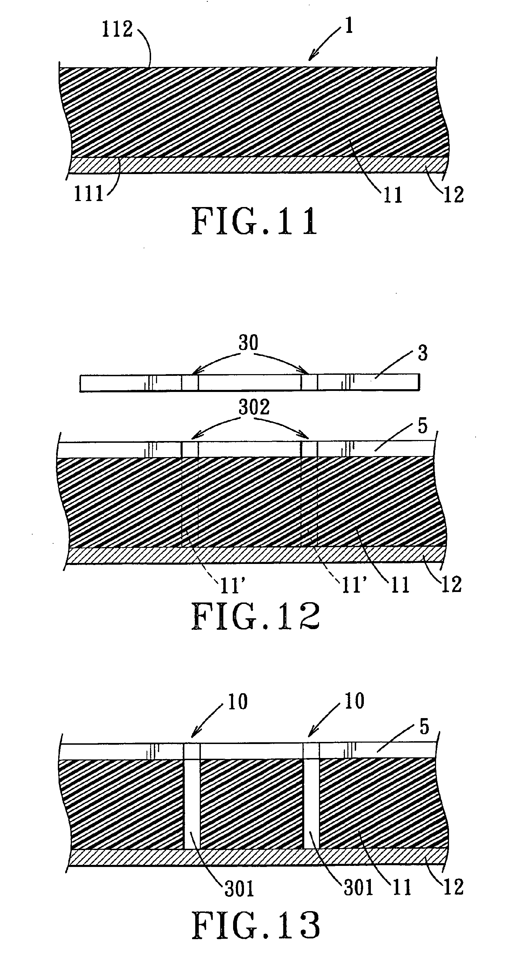

In step 200, with further reference to Figure 11, a printed circuit board 1 is provided. The printed circuit board 1 includes a dielectric layer 11 that has a first surface 111 and a second surface 112 opposite to the first surface 111, and a conductor layer 12 formed on the first surface 111 of the dielectric layer 11. In this embodiment, the dielectric layer 11 is made from epoxy resin. The conductor layer 12 is made from copper foil.

The printed circuit board 1 further includes a photo-resist layer 5 coated on the second surface 112 of the dielectric layer 11, as best shown in Figure 12.

In step 202, with further reference to Figure 12, the photo-resist layer 5 is patterned to expose parts 11' of the second surface 112 of the dielectric layer 11. A photo-mask 3 is patterned with two parallel lines of a pattern 30 and is then placed above the photo-resist layer 5. The printed circuit board 1 is subsequently exposed to radiation for transferring the pattern 30 on the photo-mask 3 to the photo-resist layer 5. A developing solution is used to form recesses 302 in the photo-resist layer 5 corresponding to the pattern 30.

In step 204, with further reference to Figure 13, a hole unit 10 is formed in the exposed parts 11' (see Figure 12) of the second surface 112 of the dielectric layer 11. The hole unit 10 includes first and second holes 301. In this embodiment, each of the first and second holes 301 of the hole unit 10 extends from the second surface 112 to the first surface 111. Preferably, the hole unit 10 is formed by dry etching. In an alternative embodiment, the hole unit 10 is formed by wet etching.

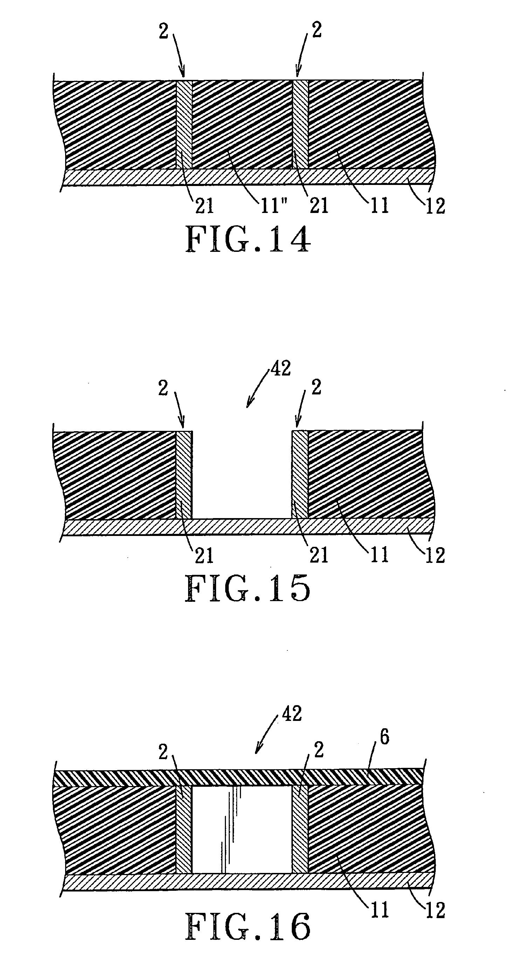

In step 206, with further reference to Figure 14, the hole unit 10 (see Figure 13) is filled with a metal structure 2. The metal structure 2 includes first and second metal members 21. In this embodiment, each of the first and second metal members 21 of the metal structure 2 extends from the first conductor layer 12 to the second surface 112 of the dielectric layer 11. Preferably, the metal structure 2 is formed by electroforming.

In step 208, with further reference to Figure 15, a portion 11" (see Figure 14) of the dielectric layer 11 is removed to result in the microstructure 42. The removed portion 11" of the dielectric layer 11 is adjacent to the conductor layer 12, and the first and second metal members 21 of the metal structure 2. In this embodiment, the microstructure 42 is a micro-groove structure that has three sides defined by the first and second metal members 21 of the metal structure 2, and the conductor layer 12. The microstructure 42 of this embodiment is suitable for applications such as fluid conduction and heat exchange. Preferably, the removed portion 11" of the dielectric layer 11 is removed by wet or dry etching.

An example of an application of the microstructure 42 of this embodiment is illustrated in Figure 16. A cover member 6 (e.g. a printed circuit board or a protective layer of a chip) is disposed on the second surface 112 of the dielectric layer 11 to cover an opening of the microstructure 42. The microstructure 42 serves as a cooling system for the cover member 6. The cover member 6 is bonded to the metal structure 2 with the use of a bonding material (not shown), such as glue. If the cover member 6 is made from metal, it can be bonded to the metal structure 2 by diffusion bonding, soldering, brazing, or diffusion soldering.

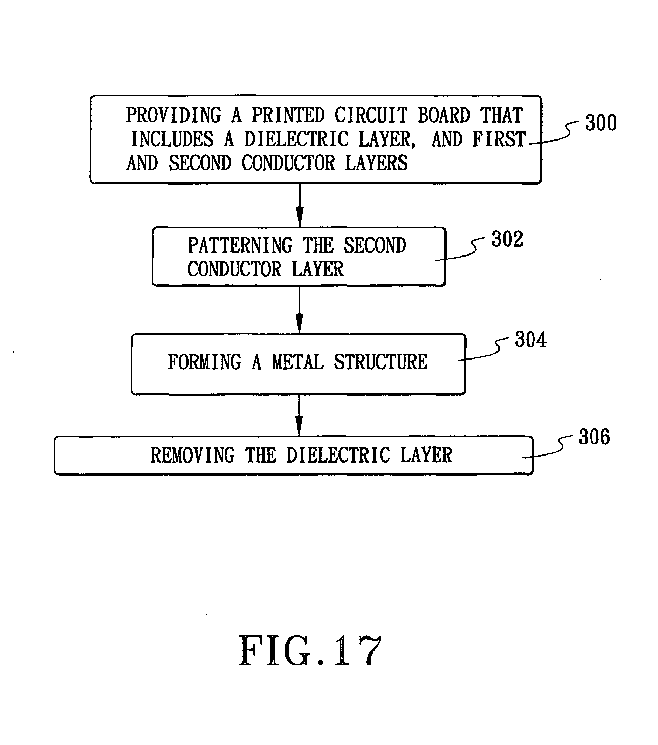

The third preferred embodiment of a method for making a microstructure according to this invention includes the steps as shown in Figure 17.

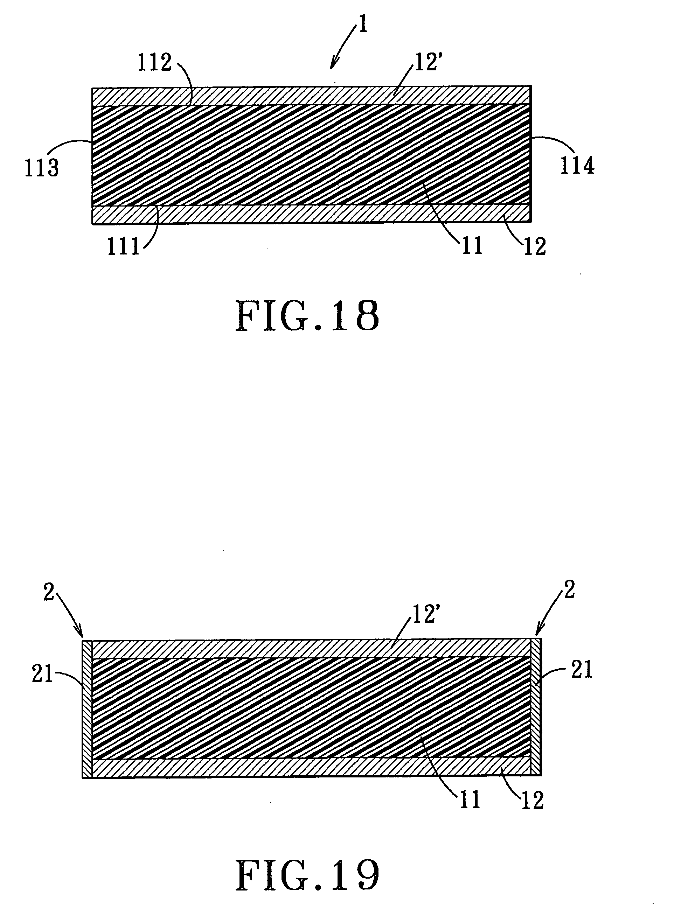

In step 300, with further reference to Figure 18, a printed circuit board 1 is provided. The printed circuit board 1 includes a dielectric layer 11 that has a first surface 111, a second surface 112 opposite to the first surface 111, and opposite edges 113, 114 that interconnect the first and second surfaces 111, 112. In this embodiment, the dielectric layer 11 is made from epoxy resin.

The printed circuit board 1 further includes first and second conductor layers 12, 12'. Each of the first and second conductor layers 12, 12' is formed on a respective one of the first and second surfaces 111, 112. In this embodiment, the first and second conductor layers 12, 12' are made from copper foil.

In step 302, with further reference to Figure 19, a metal structure 2 is formed on the printed circuit board 1. The metal structure 2 includes first and second metal members 21 formed on the opposite edges 113, 114. In this embodiment, each of the first and second metal members 21 of the metal structure 2 extends from the first conductor layer 12 to the second conductor layer 12'. Preferably, the metal structure 2 is formed by electroforming.

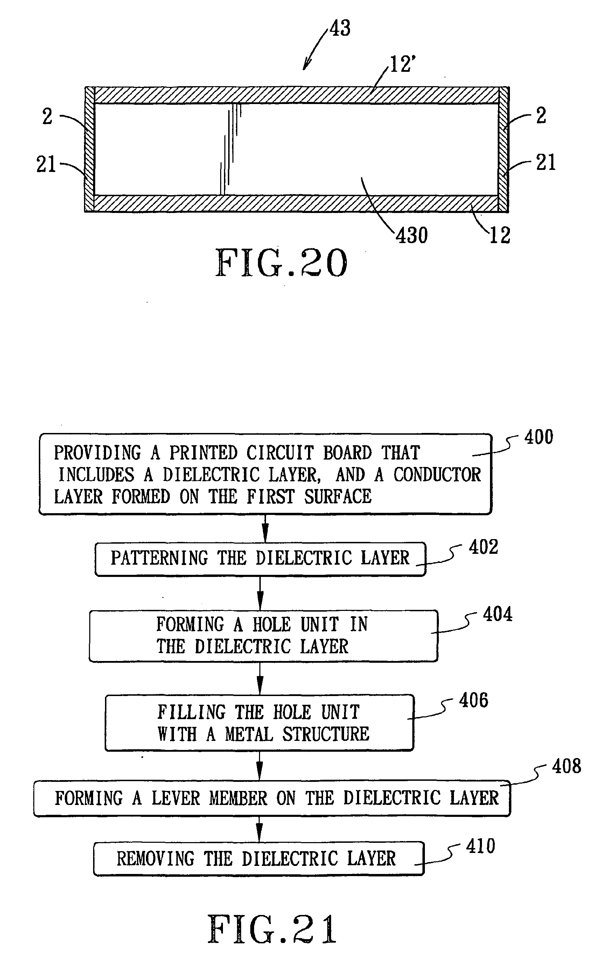

In step 304, with further reference to Figure 20, the dielectric layer 11 is removed in its entirety to result in the microstructure 43. Therefore, in this embodiment, the microstructure 43 is a hollow microstructure that has four sides defined by the first and second metal members 21 of the metal structure 2, and the first and second conductor layers 12, 12'. The microstructure 43 of this embodiment is suitable for applications, such as fluid buffering, storing and dispensing. Preferably, the removal of the dielectric layer 11 is conducted through wet etching. In another embodiment, the removal of the dielectric layer 11 is conducted by first forming a hole through one of the first and second conductor layers 12, 12', and the first and second metal members 21 of the metal structure 2. The dielectric layer 11 is then removed through precision micro machining. In yet another embodiment, the dielectric layer 11 is removed through laser ablation.

The fourth preferred embodiment of a method for making a microstructure according to this invention includes the steps as shown in Figure 21.

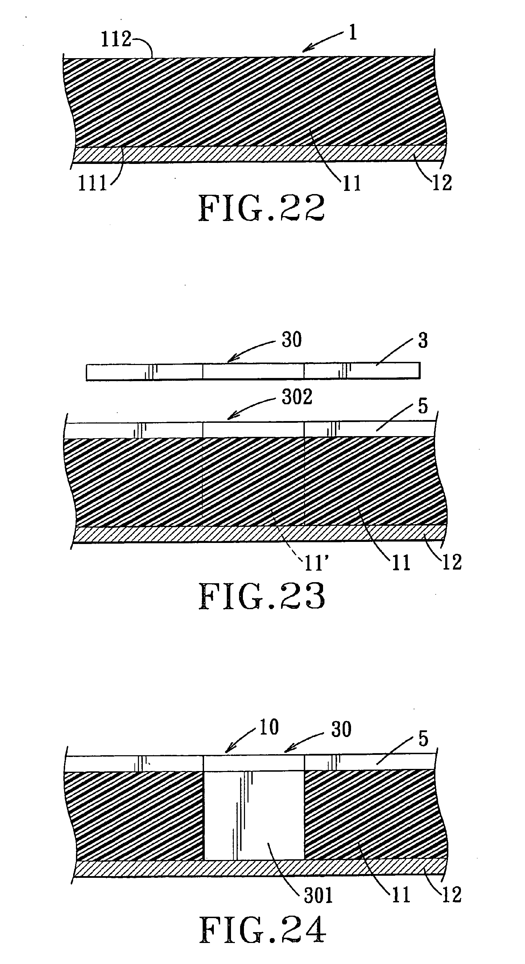

In step 400, with further reference to Figure 22, a printed circuit board 1 is provided. The printed circuit board 1 includes a dielectric layer 11 that has a first surface 111 and a second surface 112 opposite to the first surface 111, and a conductor layer 12 formed on the first surface 111. In this embodiment, the dielectric layer 11 is made from epoxy resin. The conductor layer 12 is made from copper foil.

The printed circuit board 1 further includes a photo-resist layer 5 coated on the second surface 112 of the dielectric layer 11, as best shown in Figure 23.

In step 402, with further reference to Figure 23, the photo-resist layer 5 is patterned to expose a part 11' of the second surface 112 of the dielectric layer 11. A photo-mask 3 is patterned with a circle of a pattern 30 and is then placed above the photo-resist layer 5. The printed circuit board 1 is subsequently exposed to radiation for transferring the pattern 30 on the photo-mask 3 to the photo-resist layer 5. A developing solution is used to form a recess 302 in the photo-resist layer 5 corresponding to the pattern 30.

In step 404, with further reference to Figure 24, a hole unit 10 is formed in the exposed part 11' (see Figure 23) of the second surface 112 of the dielectric layer 11. The hole unit 10 includes a hole 301. In this embodiment, the hole 301 of the hole unit 10 extends from the second surface 112 to the first surface 111. Preferably, the hole 301 of the hole unit 10 is formed by dry or wet etching.

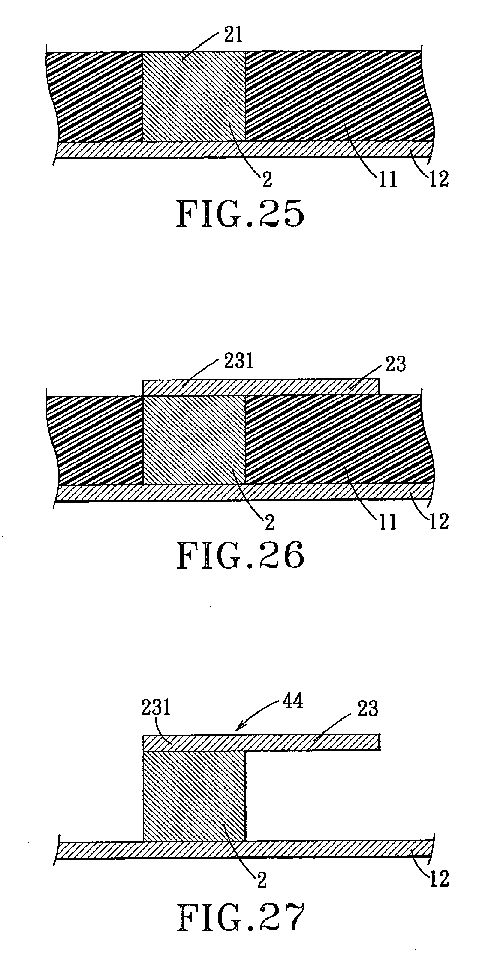

In step 406, with further reference to Figure 25, the hole unit 10 (see Figure 24) is filled with a metal structure 2. The metal structure 2 includes a metal member 21. In this embodiment, the metal member 21 of the metal structure 2 extends from the conductor layer 12 to the second surface 112 of the dielectric layer 11. Preferably, the metal structure 2 is formed by electroforming.

In step 408, with further reference to Figure 26, a lever member 23 is formed on the second surface 112 of the dielectric layer 11, and has a first end 231 connected to the metal member 21 of the metal structure 2 in the hole 301 of the hole unit 10.

In step 410, with further reference to Figure 27, the dielectric layer 11 is removed in its entirety to result in the microstructure 44. In this embodiment, the microstructure 44 is a micro-cantilever structure. The microstructure 44 of this embodiment is suitable for applications such as micro mechanical filters, micro gyroscopes, and micro relays. Preferably, the removal of the dielectric layer 11 is conducted through wet etching.

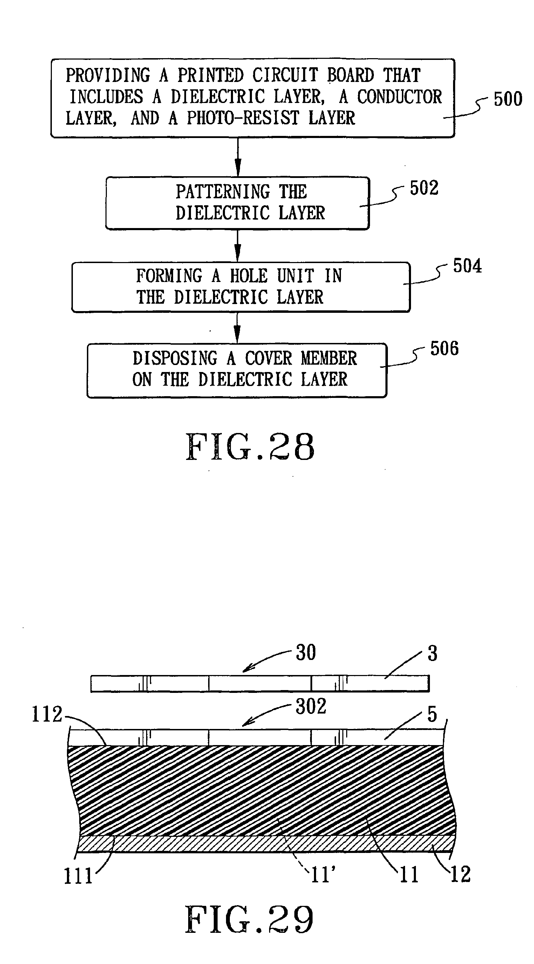

The fifth preferred embodiment of a method for making a microstructure according to this invention includes the steps as shown in Figure 28.

In step 500, with further reference to Figure 29, a printed circuit board 1 is provided. The printed circuit board 1 includes a dielectric layer 11 that has a first surface 111 and a second surface 112 opposite to the first surface 111, and a conductor layer 12 formed on the first surface 111 of the dielectric layer 11. In this embodiment, the dielectric layer 11 is made from epoxy resin. The conductor layer 12 is made from copper foil.

The printed circuit board 1 further includes a photo-resist layer 5 coated on the second surface 112 of the dielectric layer 11.

In step 502, the photo-resist layer 5 is patterned to exposed a part 11' of the second surface 112 of the dielectric layer 11. A photo-mask 3 is patterned with a straight line of a pattern 302 and is then placed on the photo-resist layer 5. The printed circuit board 1 is subsequently exposed to radiation for transferring the pattern 30 on the photo-mask 3 to the photo-resist layer 5. A developing solution is used to form a recess 302 in the photo-resist layer 5 corresponding to the pattern 30.

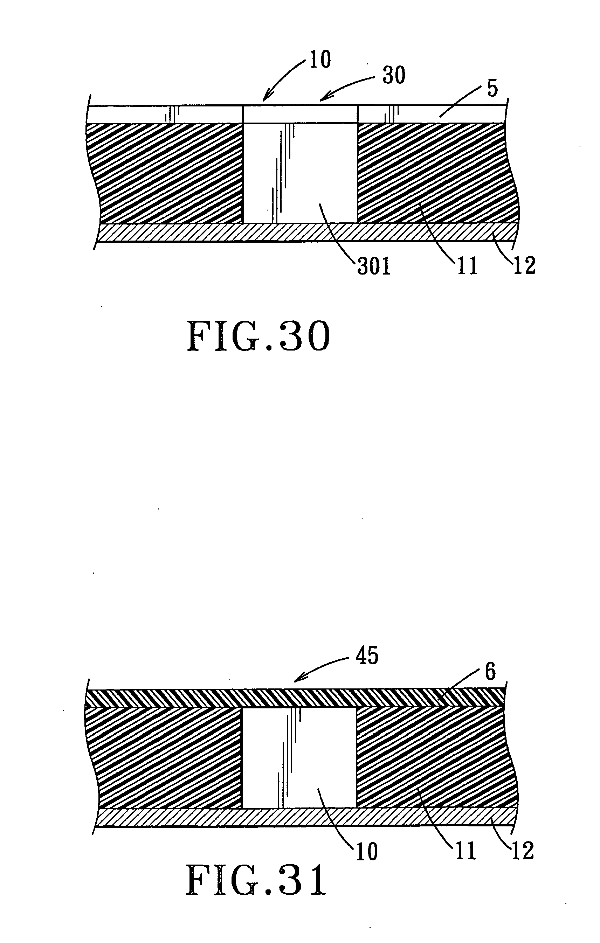

In step 504, with further reference to Figure 30,a hole unit 10 is formed in the exposed part 11' (see Figure 29) of the second surface 112 of the dielectric layer 11. The hole unit 10 includes a hole 301 that is confined by a hole-defining wall and that extends from the second surface 112 to the first surface 111. Preferably, the hole unit 10 is formed by dry or wet etching.

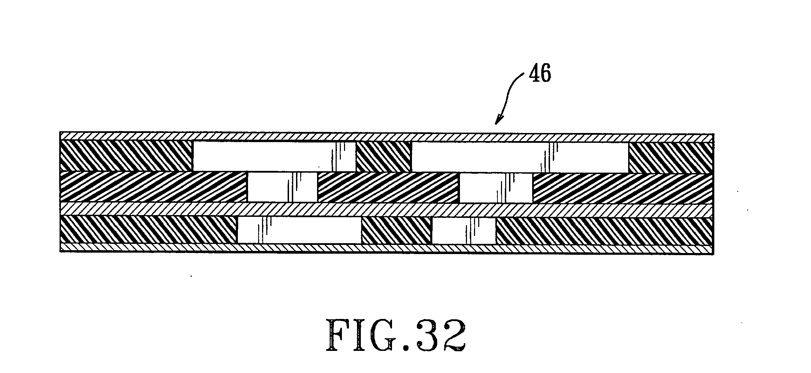

In step 506, with further reference to Figures 31 and 32, a cover member 6 is disposed on the second surface 112 of the dielectric layer 11 to result in the microstructure 45. In this embodiment, the microstructure 45 is a hollow microstructure that has four sides confined by the hole-defining wall, the conductor layer 12, and the cover member 6. The cover member 6 is in the form of a printed circuit board. As such, printed circuit boards 5 can be stacked and bonded together after processing to result in a multi-layer circuit board device 46, as best shown in Figure 32. In alternative embodiments, the cover member 6 may be one of a metal plate, an insulator plate, and an integrated circuit chip.

It is noted that although the metal structure 2 is exemplified as being formed by electroforming, it should be apparent to those skilled in the art that the metal structure 2 may be formed by one of electro-plating, electroless-plating, thin film deposition, and sputtering. Moreover, although the metal structure 2 is exemplified as made of copper, it should be apparent to those skilled in the art that any material suitable for forming the metal structure 2 through electro-forming, electro-plating, electroless-plating, thin film deposition, and sputtering may be used. Further, since the first and second conductive layers 12, 12' are made from copper foil, and the first and second metal members 21 of the metal structure 2 are made from copper, each of the microstructures 41, 42, 43, 44 has a high structural strength and good heat conduction characteristics.

It has thus been shown that the method for making microstructures 41, 42, 43, 44, 45 according to this invention includes the step of removing at least a portion 11" of a dielectric layer 11 of a printed circuit board 1. By adding this new step, high aspect ratio microstructures 41, 42, 43, 44, 45 can be fabricated using batch processing techniques at a relatively low cost.

## Claims

1. A method of making a microstructure (41, 42, 44, 45), **characterized by** the steps of:
(A) providing a circuit board (1) that includes a dielectric layer (11) having a first surface (111) and a second surface (112) opposite to the first surface (111), and a first conductor layer (12) formed on the first surface (111) of the dielectric layer (11);
(B) forming a metal structure (2) on the circuit board (1) extending from the first conductor layer (12) toward the second surface (112) of the dielectric layer (11), said step (B) including the sub-steps of
(a) forming a hole unit (10) in the dielectric layer (11) that extends from the second surface (112) to the first surface (111), and
(b) filling the hole unit (10) with the metal structure (2); and
(C) removing at least a portion (11") of the dielectric layer (11) adjacent to the first conductor layer (12) and the metal structure (2) to result in the microstructure (41, 42, 44, 45) having one side defined by the first conductor layer (12).

2. The method of Claim 1, **characterized in that**, in step (A), the circuit board (1) further includes a second conductor layer (12') formed on the second surface (112) of the dielectric layer (11),
the sub-step (a) including:
(i) patterning the second conductor layer (12') to expose parts (11') of the second surface (112) of the dielectric layer (11), and
(ii) forming the hole unit (10) in the exposed parts (11') of the second surface (112) of the dielectric layer (11).

3. The method of Claim 1, **characterized in that** the metal structure (2) is formed by one of electro-forming, electro-plating, electroless-plating, thin film deposition, and sputtering.

4. The method of Claim 1, **characterized in that**, in step (A), the circuit board (1) further includes a photo-resist layer (5) coated on the second surface (112) of the dielectric layer (11),
the sub-step (a) including:
(i) patterning the photo-resist layer (5) to expose parts (11') of the second surface (112) of the dielectric layer (11), and
(ii) forming the hole unit (10) in the exposed parts (11') of the second surface (112) of the dielectric layer (11).

5. The method of Claim 1, further **characterized by** the step of:
disposing a cover member (6) on the second surface (112) of the dielectric layer (11) after step (C).

6. The method of Claim 1, further **characterized by** the step of:
forming a lever member (23) on the second surface (112) of the dielectric layer (11) after sub-step (b), the lever member (23) having one end (231) connected to the metal structure (2) in the hole unit (10).

7. The method of Claim 1, **characterized in that** removal of the dielectric layer (11) in step (C) is conducted through one of laser ablation, etching, precision machining, and pyrolysis.

8. A method of making a microstructure (43), **characterized by** the steps of:
(A) providing a circuit board (1) that includes a dielectric layer (11) having a first surface (111) and a second surface (112) opposite to the first surface (111), opposite edges (113, 114) interconnecting the first and second surfaces (111, 112) of the dielectric layer (11), a first conductor layer (12) formed on the first surface (111) of the dielectric layer (11), and a second conductor layer (12') formed on the second surface (112) of the dielectric layer (11);
(B) forming a metal structure (2) on the circuit board (1) on the opposite edges (113, 114) of the dielectric layer (11) and extending from the first conductor layer (12) toward the second surface (112) of the dielectric layer (11); and
(C) removing at least a portion of the dielectric layer (11) adjacent to the first conductor layer (12) and the metal structure (2) to result in the microstructure (43) having one side defined by the metal structure (2).

## Patentansprüche

1. Verfahren zum Herstellen einer Mikrostruktur (41, 42, 44, 45), durch die Schritte gekennzeichnet:
(A) Bereitstellen einer Leiterplatte (1), die eine dielektrische Schicht (11) mit einer ersten Oberfläche (111) und einer der ersten Oberfläche (111) gegenüber liegenden zweiten Oberfläche (112), und eine erste leitende Schicht (12), die auf der ersten Oberfläche (111) der dielektrischen Schicht (11) ausgebildet ist, beinhaltet;
(B) Ausbilden einer Metallstruktur (2) auf der Leiterplatte (1), die sich von der ersten leitenden Schicht (12) hin zu der zweiten Oberfläche (112) der dielektrischen Schicht (11) erstreckt, wobei der Schritt (B) die Unterschritte beinhaltet:
(a) Ausbilden einer Locheinheit (10) in der dielektrischen Schicht (11), die sich von der zweiten Oberfläche (112) zu der ersten Oberfläche (111) erstreckt, und
(b) Auffüllen der Locheinheit (10) mit der Metallstruktur (2); und
(C) Entfernen von mindestens einem Abschnitt (11") der dielektrischen Schicht (11) angrenzend an die erste leitende Schicht (12) und die Metallstruktur (12), was darin resultiert, dass die Mikrostruktur (41, 42, 44, 45) eine Seite hat, die durch die erste leitende Schicht (12) definiert ist.

2. Verfahren nach Anspruch 1, **dadurch gekennzeichnet, dass** in Schritt (A) die Leiterplatte (1) weiterhin eine zweite leitende Schicht (12') beinhaltet, die auf der zweiten Oberfläche (112) der dielektrischen Schicht (11) ausgebildet ist,
wobei der Unterschritt (a) beinhaltet:
(i) Strukturieren der zweiten leitenden Schicht (12'), um Teile (11') der zweiten Oberfläche (112) der dielektrischen Schicht (11) freizulegen und
(ii) Ausbilden der Locheinheit (10) in den freigelegten Teilen (11') der zweiten Oberfläche (112) der dielektrischen Schicht (11).

3. Verfahren nach Anspruch 1, **dadurch gekennzeichnet, dass** die Metallstruktur (2) mittels eines der folgenden ausgebildet wird: Elektroformen, Strommetallisieren, Stromlos-Metallisieren, Dünnfilm-Deposition und Sputtern.

4. Verfahren nach Anspruch 1, **dadurch gekennzeichnet, dass** in Schritt (A) die Leiterplatte (1) weiterhin eine Photolackschicht (5) beinhaltet, mit der die zweite Oberfläche (112) der dielektrischen Schicht (11) überzogen ist,
wobei der Unterschritt (a) beinhaltet:
(i) Strukturieren der Photolackschicht (5), um Teile (11') der zweiten Oberfläche (112) der dielektrischen Schicht (11) freizulegen, und
(ii) Ausbilden der Locheinheit (10) in den freigelegten Teilen (11') der zweiten Oberfläche (112) der dielektrischen Schicht (11).

5. Verfahren nach Anspruch 1, weiterhin durch den Schritt gekennzeichnet:
Anordnen eines Abdeckteils (6) auf der zweiten Oberfläche (112) der dielektrischen Schicht (11) nach Schritt (C).

6. Verfahren nach Anspruch 1, weiterhin durch den Schritt gekennzeichnet:
Ausbilden eines Hebelteils (23) auf der zweiten Oberfläche (112) der dielektrischen Schicht (11) nach Unterschritt (b), wobei das Hebelteil (23) ein Ende (231) hat, das mit der Metallstruktur (2) in der Locheinheit (10) verbunden ist.

7. Verfahren nach Anspruch 1, **dadurch gekennzeichnet, dass** Entfernen der dielektrischen Schicht (11) in Schritt (C) durch eines der folgenden durchgeführt wird: Laserablation, Ätzen, Präzisionsbearbeitung und Pyrolyse.

8. Verfahren zum Herstellen einer Mikrostruktur (43), **gekennzeichnet durch** die Schritte:
(A) Bereitstellen einer Leiterplatte (1), die eine dielektrische Schicht (11) mit einer ersten Oberfläche (111) und einer der ersten Oberfläche (111) gegenüber liegenden zweiten Oberfläche (112) hat, gegenüberliegende Kanten (113, 114), die die erste und zweite Oberfläche (111, 112) der dielektrischen Schicht (11) miteinander verbinden, eine erste leitende Schicht (12), die auf der ersten Oberfläche (111) der dielektrischen Schicht (11) ausgebildet ist und eine zweite leitende Schicht (12'), die auf der zweiten Oberfläche (112) der dielektrischen Schicht (11) ausgebildet ist, beinhaltet;
(B) Ausbilden einer Metallstruktur (2) auf der Leiterplatte (1) an den gegenüberliegenden Kanten (113, 114) der dielektrischen Schicht (11) und die sich von der ersten leitenden Schicht (12) hin zu der zweiten Oberfläche (112) der dielektrischen Schicht (11) erstrecken; und
(C) Entfernen von zumindest einem Abschnitt der dielektrischen Schicht (11) angrenzend an die erste leitende Schicht (12) und die Metallstruktur (2), was darin resultiert, dass die Mikrostruktur (43) eine Seite hat, die durch die Metallstruktur (2) definiert ist.

## Revendications

1. Procédé de fabrication d'une microstructure (41, 42, 44, 45), **caractérisé par** les étapes consistant à :
(A) fournir une carte de circuit (1) qui comprend une couche diélectrique (11) ayant une première surface (111) et une seconde surface (112) opposée à la première surface (111), et une première couche conductrice (12) formée sur la première surface (111) de la couche diélectrique (11) ;
(B) former une structure métallique (2) sur la carte de circuit (1) s'étendant de la première couche conductrice (12) vers la seconde surface (112) de la couche diélectrique (11), ladite étape (B) comprenant les sous-étapes consistant à
(a) former une unité à trou (10) dans la couche diélectrique (11) qui s'étend de la seconde surface (112) à la première surface (111), et
(b) remplir l'unité à trou (10) avec la structure métallique (2) ; et
(C) retirer au moins une partie (11") de la couche diélectrique (11) adjacente à la première couche conductrice (12) et à la structure métallique (2) pour faire en sorte que la microstructure (41, 42, 44, 45) ait un côté défini par la première couche conductrice (12).

2. Procédé selon la revendication 1, **caractérisé en ce que**, à l'étape (A), la carte de circuit (1) comprend en outre une seconde couche conductrice (12') formée sur la seconde surface (112) de la couche diélectrique (11),
la sous-étape (a) comprenant :
(i) l'agencement de la seconde couche conductrice (12 ') pour exposer des parties (11') de la seconde surface (112) de la couche diélectrique (11), et
(ii) la formation de l'unité à trou (10) dans les parties exposées (11') de la seconde surface (112) de la couche diélectrique (11).

3. Procédé selon la revendication 1, **caractérisé en ce que** la structure métallique (2) est formée par l'un parmi l'électroformage, l'électrodéposition, la déposition autocatalytique, le dépôt de couches minces et la pulvérisation cathodique.

4. Procédé selon la revendication 1, **caractérisé en ce que**, à l'étape (A), la carte de circuit (1) comprend en outre une couche de photorésist (5) appliquée sur la seconde surface (112) de la couche diélectrique (11),
la sous-étape (a) comprenant :
(i) l'agencement de la couche de photorésist (5) pour exposer des parties (11') de la seconde surface (112) de la couche diélectrique (11), et
(ii) la formation de l'unité à trou (10) dans les parties exposées (11') de la seconde surface (112) de la couche diélectrique (11).

5. Procédé selon la revendication 1, **caractérisé en outre par** l'étape consistant à :
disposer un élément de recouvrement (6) sur la seconde surface (112) de la couche diélectrique (11) après l'étape (C).

6. Procédé selon la revendication 1, **caractérisé en outre par** l'étape consistant à :
former un élément à levier (23) sur la seconde surface (112) de la couche diélectrique (11) après la sous-étape (b), l'élément à levier (23) ayant une extrémité (231) connectée à la structure métallique (2) dans l'unité à trou (10).

7. Procédé selon la revendication 1, **caractérisé en ce que** le retrait de la couche diélectrique (11) à l'étape (C) est conduit à travers l'un parmi l'ablation laser, l'attaque chimique, l'usinage de précision et la pyrolyse.

8. Procédé de fabrication d'une microstructure (43), **caractérisé par** les étapes consistant à :
(A) fournir une carte de circuit (1) qui comprend une couche diélectrique (11) ayant une première surface (111) et une seconde surface (112) opposée à la première surface (111), des bords opposés (113, 114) interconnectant les première et seconde surfaces (111, 112) de la couche diélectrique (111), une première couche conductrice (12) formée sur la première surface (111) de la couche diélectrique (11), et une seconde couche conductrice (12') formée sur la seconde surface (112) de la couche diélectrique (11) ;
(B) former une structure métallique (2) sur la carte de circuit (1) sur les bords opposés (113, 114) de la couche diélectrique (11) et s'étendant de la première couche conductrice (12) vers la seconde surface (112) de la couche diélectrique (11) ; et
(C) retirer au moins une partie de la couche diélectrique (11) adjacente à la première couche conductrice (12) et à la structure métallique (2) pour faire en sorte que la microstructure (43) ait un côté défini par la structure métallique (2).
